Europäisches Patentamt

European Patent Office

Office européen des brevets

(19)

(11) Veröffentlichungsnummer: **0 203 369 B1**

(12) **EUROPÄISCHE PATENTSCHRIFT**

(45) Veröffentlichungstag der Patentschrift: **16.10.91**

(51) Int. Cl.⁵: **G01R 1/02**, F16B 2/24

(21) Anmeldenummer: **86105598.6**

(22) Anmeldetag: **23.04.86**

(54) **Anordnung für oder in Dreheisen- bzw. Drehspulinstrumenten.**

(30) Priorität: **09.05.85 DE 3516684**

(43) Veröffentlichungstag der Anmeldung:
**03.12.86 Patentblatt 86/49**

(45) Bekanntmachung des Hinweises auf die
Patenterteilung:
**16.10.91 Patentblatt 91/42**

(84) Benannte Vertragsstaaten:
**CH DE FR GB IT LI SE**

(56) Entgegenhaltungen:
**DE-C- 1 816 963**
**DE-C- 1 919 244**
**DE-U- 7 626 054**
**US-A- 3 453 926**
**US-A- 4 238 731**

(73) Patentinhaber: **Rivoir, Karl Heinz**
**Am Nagoldhang 5**
**W-7530 Pforzheim(DE)**

(72) Erfinder: **Rivoir, Karl Heinz**
**Am Nagoldhang 5**
**W-7530 Pforzheim(DE)**

(74) Vertreter: **Richter, Bernhard, Dipl.-Ing.**
**Beethovenstrasse 10**
**W-8500 Nürnberg 20(DE)**

## Beschreibung

Die Erfindung betrifft eine Anordnung für oder in Dreheisen- bzw. Drehspulinstrumenten mit einer Achse und einem Drehelement (Drehspule oder in Form eines Kreissegmentes ausgebildetes Dreheisen), wobei das Drehelement an der Achse über zwei Arme angebracht ist. Derartige Anordnungen aus einer Achse und dem Dreheisen bzw. der Drehspule, einschließlich der zugehörigen, an der Achse befestigten Armen, sind aus der DE-C-18 16 963 bekannt. Wenn auch die dort vorgesehene Ausgestaltung der Achse sich bewährt hat, so ist doch die dort notwendige Montage des Drehelementes mit seinen Armen an der Achse sehr umständlich und damit zeitraubend sowie kostspielig, da dort nämlich diese Montage durch Einstecken der Achse in Bohrungen der Enden der Arme erfolgen muß. ein solches Einfädeln muß von Hand geschehen oder es muß automatisch mit einem sehr großen Aufwand durchgeführt werden. Beides ist aus Rationalisierungsgründen nicht mehr tragbar. Hinzu kommt die Gefahr, daß bei dem Einfädeln die an der Achse befindlichen, sehr empfindlichen Lagerspitzen an den Enden der Arme bzw. neben der jeweiligen Bohrung anstoßen und damit beschädigt werden. Hinzu kommt als weiterer Nachteil, daß das bei dieser Vorveröffentlichung vorgesehene Vernieten nur bei einem der Arme des Drehelementes mit einem Bund der Achse möglich ist, da wegen der vorgenannten Erfordernis des Einfädelns man auf der Achse nicht zwei Bunde für das Annieten beider Arme des Drehelementes vorsehen kann. Ist das Drehelement aber nur mit einem Arm fest angenietet und mit dem anderen Arm nur lose oder mit einem mehr oder weniger festen Sitz an der Achse gehalten, so kann dies insbesondere bei größeren und damit schwereren Drehelementen zu einer labilen Anbringung des Drehelementes führen. Dies hat eine Beeinträchtigung der Reproduzierbarkeit der sogenannten Skalencharakteristik, d.h. der jeweiligen Anzeige des Drehelementes Zur Folge. Dieser Nachteil ist schwerwiegend, weil solche Skalen aus Kostengründen reproduzierbar sein müssen und nicht etwa für jedes Drehelement eine gesonderte Skala (nach entsprechender Eichung) von Hand angefertigt werden kann. Ist das Drehelement als Drehspule ausgebildet, so kommt hinzu, daß insbesondere bei größeren und damit schwereren Drehspulen, aufgrund des Spulengewichtes ein solches "einhüftig" befestigtes Drehelement keine ausreichende Stabilität mehr hat. Es kann nur ein Arm angenietet werden. Ist ein zweiter Arm vorhanden, der nicht angenietet werden kann, so kann dieser Arm nur auf die Achse aufgesteckt werden. Es besteht dann aufgrund von Fertigungstoleranzen die Gefahr von Vibrationen des Drehelementes zur

Achse. Bei einem zu festen Gegenspannen des zweiten Armes auf der Achse besteht die Gefahr von Verspannungen. Bei all dem ist auch noch zu berücksichtigen, daß auf der Achse noch andere Bauteile, wie ein Zeigerkreuz und eine Dämperfahne befestigt sind und daß diese Teile in Umfangsrichtung eine bestimmte Relation (Winkellage) zum Drehelement haben müssen. Es muß also das Drehelement bei seiner Befestigung an der Achse auch in Umfangsrichtung justiert sein. Dies kann bei dem erläuterten Stand der Technik Schwierigkeiten in der Fertigung mit sich bringen.

Aus der DE-C-19 19 244 ist es zwar bekannt, ein Dreheisenplättchen in Schlitze von Bunden einzustecken, die mit der Achse gemäß DE-C-18 16 963 einstückig sind. Hiermit ist aber nur eine Befestigung von flachen, sich in Radialrichtung erstreckenden Dreheisenplättchen möglich, nicht jedoch die Befestigung von Dreheisen in Form eines Kreissegmentes und von Drehspulen, die beide jeweils mit Armen für ihre Befestigung an der Achse versehen sind. Dreheisen in Kreissegmentform werden aber für viele Anwendungen benötigt. Eine Anordnung gemäß der Patentschrift DE-C-19 19 244 erfüllt also nicht den Oberbegriff des Anspruches 1. Es hat im übrigen noch den weiteren Nachteil, daß für die Justierung des Drehelementes in Längsrichtung der Achse an dieser zusätzlich zu den Befestigungsbunden noch mindestens ein Justieranschlag vorgesehen sein muß. Die Anbringung des Dreheisenplättchens an den Bunden erfolgt nur über sehr kleine Querschnitte und kann sich daher wieder lösen.

Aus US-A-3 453 926 ist eine Befestigung eines Stiftes an einem Montagestreifen bekannt, wobei der Montagestreifen den Stift gabelartig umgeben kann. Eine solche Anordnung betrifft also nicht den Oberbegriff des Anspruches 1, der eingangs zitiert wurde. Sie zeigt nämlich weder eine Anordnung für oder in Dreheisen- bzw. Drehspulinstrumente mit einer Achse und einem daran angebrachten Drehelement. Ferner zeigt die Anordnung nach US-A-3 453 926 auch nicht die Anbringung des Drehelementes an der Achse über zwei Arme, erfüllt also auch nicht dieses Merkmal des Oberbegriffes des Anspruches 1 der vorliegenden Erfindung. Die Befestigung des Stiftes am Montagestreifen erfolgt bei US-A-3 453 926 in der Weise, daß ausdrücklich eine Verdrehbarkeit des Montagestreifens um die Stiftachse, d.h. in Umfangsrichtung des Stiftes erfolgen soll, und daß außerdem eine Auswechselbarkeit des Montagestreifens von dem Stift geschehen soll und zwar mittels einer nachgiebigen und gabelartigen Anbringung der Enden des Montagestreifens am Stift. Damit ist also in Umfangsrichtung überhaupt keine Fixierung der Lage des Montagestreifens zum Stift gegeben. Auch besteht keine unverrückbare Befestigung des Montagestreifens am Stift in dessen Axial- und Radialrichtung, da dem die vorstehend erläuterte Auswechselbarkeit des Montagestreifens zum Stift und auch die elastische Halterung des Montagestreifens am Stift entgegenstehen würden. Beim Gegenstand dieser Vorveröffentlichung werden Stift und Montagestreifen nur durch ein federndes Einschnappen vor dem Herausfallen geschützt. Dies aber entspricht nicht nachstehender Aufgabestellung und auch nicht der nachstehend erläuterten Lösung der Erfindung.

Die Aufgabe der Erfindung besteht demgegenüber darin, eine Anordnung gemäß dem Oberbegriff des Anspruches 1 (siehe DE-C-18 16 963 dahingehend zu verbessern, daß die zum Stand der Technik erläuterten Nachteile vermieden werden, d.h. demgegenüber eine einfache und mit geringen Kosten durchführbare, dabei aber den Festigkeitsanforderungen einer Anordnung nach dem Oberbegriff voll genügenden Anbringung des jeweiligen Drehelementes an der Achse erzielt wird, wobei das Drehelement als Drehspule oder als kreissegmentförmiges Dreheisen, jeweils mit den zugehörigen Armen, ausgebildet sein soll.

Zur Lösung dieser Aufgabe ist, ausgehend vom Oberbegriff des Anspruches 1, vorgesehen, daß die freien Enden der Arme des Drehelementes eine Schlitzung von einer Form und Abmessungen aufweisen, daß die Achse in die Schlitzungen paßt, und daß diese freien Enden von der Seite her, d.h. etwa senkrecht zur Achsenlängsrichtung gabelartig auf die Achse gesteckt sind, wobei die durch die Schlitzung gebildeten Zinken dieser freien Enden seitlich neben der Achse liegen und an dieser direkt oder über Zwischenteile gegen Verlagerungen in Achsrichtung, quer zur Achsrichtung und in Umfangsrichtung der Achse unverrückbar befestigt sind. Durch dieses seitliche Aufschieben der durch die Schlitzung gebildeten Teile (im folgenden der Einfachheit halber "Zinken" genannt) der freien Armenden über die Achse wird das nachteilige und umständliche Einfädeln in Längsrichtung der Achse gemäß dem eingangs erläuterten Stand der Technik vermieden. Dieses seitliche Aufschieben der Zinken verlangt demgegenüber einen wesentlich kürzeren Schiebeweg und ist daher mit einem wesentlich geringeren Montageaufwand durchführbar, da es relativ leicht mechanisiert (automatisiert) werden kann. Die Gefahr der Beschädigung der Achsspitzen entfällt. Die Zinken befinden sich beiderseits der Achse und werden mit ihr, bevorzugt an den später zu erläuternden Bunden, in allen vorgenannten drei Bewegungsebenen unverrückbar fest verbunden, und zwar weiter bevorzugt durch das nachstehend erläuterte mechanische Verformen. Aber auch durch andere Befestigungsarten, wie Löten, Verschweißen oder Verkleben sind möglich. Die erläuterten Gefahren und Nachteile einer ungenügenden Befestigung, wie bei den Anordnungen nach DE-C-19 19 244 und US-A-34 53 926 entfallen, was insbesondere auch für die zum Stand der Technik erläuterten schädlichen Vibrationen gilt. Dies ist deswegen wichtig, weil mit Anordnungen nach der Erfindung ausgerüstete Meßinstrumente auch auf Fahrzeugen und auf Generatoren eingesetzt werden, in denen sie erheblichen Stößen und Schwingungen ausgesetzt sind. Die genaue und unverrückbare Positionierung des Drehelementes in Achsrichtung, radial zur Achse und vor allen Dingen in der Umfangsrichtung ist wichtig, weil sich andernfalls schädliche Beeinflussungen der Skalencharakteristik des Meßinstrumentes ergeben. Insbesondere erlaubt die Erfindung ohne zusätzliche Justierarbeit das Meßwerk in Übereinstimmung mit vorgedruckten Skalen (in Bezug auf deren Charakterisitk) liefern zu können. Die sehr hohen und nicht mehr vertretbaren Kosten einer Justierarbeit werden vermieden. Zugleich wird die vorgesehene Winkel-Orientierung zum Zeiger eines solchen Instrumentes, d.h. in Umfangsrichtung der Achse, erreicht. Dies ist wichtig, weil eine Fehlposition des Meßwerkes zum Zeiger eine Beeinträchtigung der Wiederholgenauigkeit der Skalencharakteristik bedingen würde. In diesem Fall wäre nämlich entweder der Zeiger nicht mehr zur vorgedruckten Skala ausgerichtet, oder ein bewegliches Dreheisen käme in eine Fehlposition zu Festeisen an Schirmblechen und dergleichen mehr.

Gemäß einer bevorzugten Ausführungsform der Erfindung ist eine Anordnung nach Anspruch 1 vorgesehen, bei der an der Achse zwei Bunde zur Befestigung des Drehelementes angebracht, bevorzugt mit der Achse einstückig sind und wobei die beiden Arme mit den Zinken ihrer freien Enden an diesen beiden Bunden befestigt sind und diese Befestigung bevorzugt durch eine mechanische Verformung der Zinken und/oder der Bunde erfolgt. Diese mechanische Verformung kann z.B. ein Verstemmen oder eine nietähnliche Verformung sein. Die oben genannten anderen Befestigungsarten, z.B. Löten oder Verklebung, wären möglich, obgleich die mechanische Verformung hier die bevorzugte Befestigung darstellt. Daß eine solche Ausgestaltung der aus Achse und Drehelement bestehenden Anordnung beim Stand der Technik nicht möglich ist, wurde eingangs erläutert. Da die Zinken der freien Enden seitlich an den Achsen anliegen und mit ihren Spitzen noch über den Achsschaft hinausreichen können, bilden die Zinken eine genügend große Anlagefläche an dem jeweiligen Bund und damit hinreichende Befestigungsmöglichkeiten und zwar insbesondere in der bevorzugten Ausführungsform des mechanischen Verformens und dabei in Kombination und Zusammenwirken mit den übrigen Merkmalen dieses Anspruches 2 und des vorstehend erläuterten, übergeordneten Anspruches 1. Besonders vorteilhaft ist es, daß man das Aufschieben der freien Enden der Arme auf die Achse und die Verbindung dieser freien Enden bzw. deren Zinken mit Bunden der Achse durch mechanisches Verformen, einschließlich des entsprechenden Anbringens eines Zeigerträgers usw. an der Achse in einem gemeinsamen Arbeitsgang durchführen kann. Dabei ist zugleich die o.g. genaue Einhaltung der Winkelposition zwischen Zeigerträger und Drehelement durch entsprechende Ausgestaltung der Vorrichtung ohne weiteres erreichbar. Die Justierung des Drehelementes in Längsrichtung der Achse erfolgt von selbst durch die Bunde selber, so daß hierzu gesonderte Justiermittel oder- vorrichtungen entfallen. Ein weiterer Vorteil besteht darin, daß ein mechanisches Verspannen der empfindlichen Bauteile, insbesondere der weichmagnetischen Dreheisen vermieden ist. Im übrigen erlaubt die Erfindung das Annieten eines Zeigerträgers zwischen den Befestigungsstellen der Arme an der Achse.

Die Arme des Drehelementes können in einfacher Weise durch Stanzen aus Metall hergestellt werden. Die Arme könnten aber auch aus Kunststoff sein. Die Achse kann gemäß DE-PS 1816963 aus Buntmetall, bevorzugt Aluminium, ausgeführt sein, wobei die Bunde einstückig mit der Achse mit vernachlässigbaren Mehrkosten hergestellt werden können. Dies und die erläuterte Reduzierung der Montagekosten (ca. um 40%) ergibt insgesamt eine sehr erhebliche Reduzierung der Gesamtherstellungskosten einer solchen Anordnung.

Die o.g. bevorzugte Ausführungsform der Erfindung der Befestigung der freien Enden der Arme an Bunden durch mechanisches Verformen (sei es der Bunde und/oder der Zinken) kann in einer besonders bevorzugten Ausführungsform der Erfindung der Art vorgesehen sein, daß zur Befestigung jedes Endes eines Armes an der Achse zwei Bunde in einem Abstand voneinander angebracht sind, der etwa der Zinkendicke entspricht und das Einschieben der Zinken zwischen diese beiden Bunde bei gleichzeitigem seitlichen Liegen der Zinken neben der Achse, bzw. Absätzen der Achse gestattet und daß durch mechanische Verformung zwischen den jeweiligen Zinken eines freien Endes und einem Bund oder beiden Bunden des dazugehörigen Bundpaares die Befestigung gebildet ist. Das Überschieben der Zinken über die Achse von der Seite erlaubt problemlos, die Zinken eines Endes zwischen die beiden zugehörigen Bunde zu bringen. Das Befestigen der Zinken an diesen Bunden und damit an der Achse ist besonders leicht durch mechanisches Verformen möglich, da die Zinken an beiden Seiten je an einem Bund anliegen. Auch die Merkmale des vorstehend erläuterten Anspruches 3 wirken also in Kombination mit den Merkmalen des Anspruches 1 und der bevorzugten Ausführungsform des Anspruches 2 im Sinne einer besonders vorteilhaften Lösung der gestellten Aufgabe zusammen. Bei dem vorgenannten mechanischen Verformen ist es im übrigen fertigungstechnisch von Vorteil, daß dabei einer der Bunde auf einem Auflager des Verformwerkzeuges aufliegen und der andere dieser Bunde von einem entsprechenden Druckstempel oder dergleichen des Werkzeuges in Richtung zum Auflager hin gedrückt wird, so daß keine Scherkräfte in Längsrichtung der Achse auftreten.

Eine weitere fertigungstechnisch vorteilhafte Ausführungsform der Erfindung besteht darin, daß eine oder beide Zinken eines oder beider der freien Armenden zumindest eine Ausnehmung aufweisen und daß sich verformtes Material eines oder beider der Bunde in der jeweiligen Ausnehmung bzw. den Ausnehmungen eingedrückt befindet. Hierdurch wird außerdem eine besonders innige und feste Verbindung im Sinne der Erfindung zwischen Drehelement und Achse erreicht.

Weitere Merkmale und Vorteile der Erfindung sind den weiteren Unteransprüchen, sowie der nachstehenden Beschreibung und der zugehörigen Zeichnung von erfindungsgemäßen Ausführungsmöglichkeiten zu entnehmen. Die Zeichnung ist auf die zum Verständnis der Erfindung notwendigen Teile reduziert. In ihr zeigt:

Fig. 1:
ein erstes Ausführungsbeispiel der Erfindung in der Seitenansicht, z.T. im Längsschnitt,

Fig. 2a, 2b u. 3:
mögliche Ausführungen der freien Enden der Arme des Drehelementes in der Draufsicht,

Fig. 4:
in der Seitenansicht und z.T. im Schnitt ein weiteres Ausführungsbeispiel der Erfindung,

Fig. 5a, 5b u.5c:
ein Dreheisen nach der Erfindung in Seitenansicht, Stirnansicht und Draufsicht, das mit einer Achse nach Fig. 4 anstelle des dort gezeigten Drehspulrahmens verbunden werden kann,

Fig. 6:
ein weiteres Ausführungsbeispiel der Erfindung in einer Teildarstellung und im Längsschnitt und zwar in einem Schnitt gemäß der Linie VI-VI in Fig. 7,

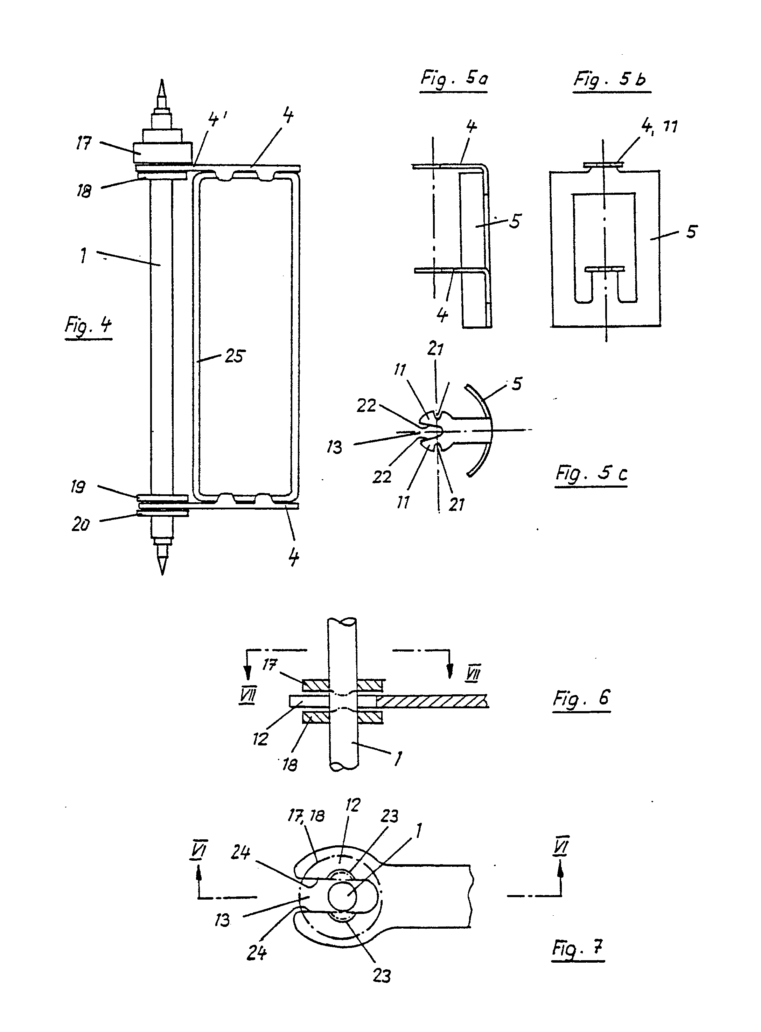

Fig. 7:
eine Draufsicht gemäß einem Schnitt nach der Linie VII-VII in Fig. 6

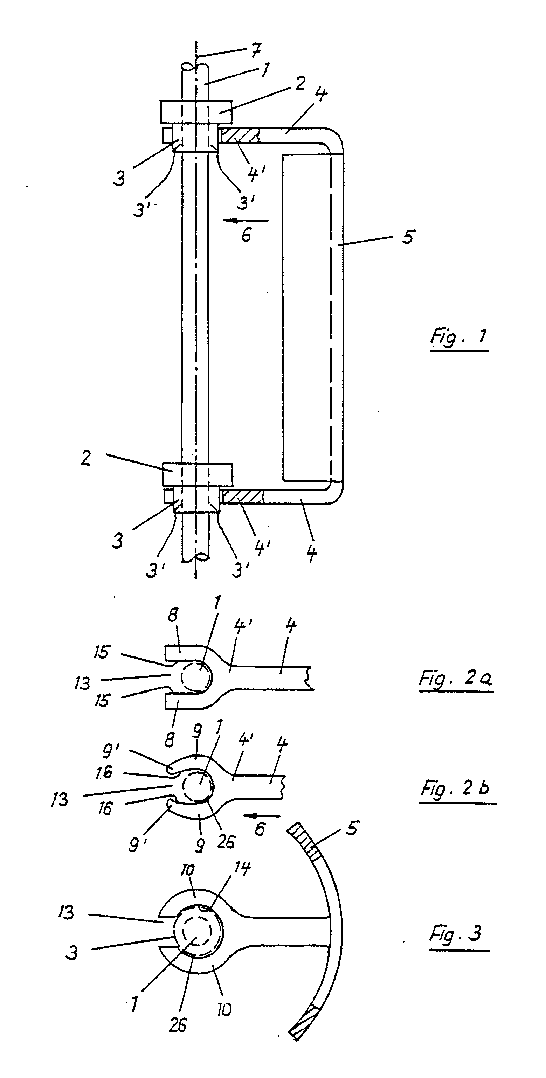

Die Achse 1 eines solchen Meßwerkes besitzt gemäß Fig. 1 zwei angedrehte Bunde 2 mit in ihrem Durchmesser demgegenüber kleineren Absätzen 3. Hierauf sind die beiden Arme 4 eines Dreheisens 5, das gemäß Fig. 3 (und auch 5c) einen kreissegmentförmigen Querschnitt hat, aufgesteckt.

Grundsätzlich bilden in allen Ausführungsbeispielen die freien Enden 4' der Arme 4 eine Art Gabel mit zwei Zinken 8 (Fig. 2a), 9 (Fig. 2b), 10 (Fig. 3), 11 (Fig. 5a bis 5c) und 12 (Fig. 6, 7).Im Prinzip gilt, daß jede dieser Zinkenausgestaltungen im Sinne der Erfindung über eine der dargestellten Achsen von der Seite her d. h. gemäß Pfeil 6 senkrecht zur Längsrichtung 7 der Achse 1 auf diese gesteckt und mit dieser fest verbunden werden kann. Die einzige Voraussetzung ist die, daß die Achse (bzw. im Ausführungsbeispiel der Fig. 1 die Absätze 3) an der entsprechenden Stelle zwischen den Zinken in diese hineinpassen, wie es auch jeweils gestrichelt eingezeichnet ist. Dabei ist hinsichtlich der Zinken 10 in dem Ausführungsbeispiel der Fig. 3 noch die Besonderheit, daß die Breite des Schlitzes 13 so sein muß, daß man die Zinken 10 über die Achse 1 schieben kann. Der Durchmesser der schlüssellochähnlichen Ausnehmung 14 muß so groß sein, daß danach diese Enden 4' der Arme 4 etwas von unten nach oben über die Ansätze 3 geschoben werden können. Danach werden die Kanten 3' dieser Ansätze nietähnlich nach oben/außen umgebogen (nicht dargestellt) und halten damit die Arme 4 an den Bunden 2 fest.

Im Ausführungsbeispiel der Fig. 2a verlaufen die Innenseiten 15 der beiden Zinken 8 etwa parallel zueinander, während im Ausführungsbeispiel der Fig. 2b die entsprechenden Innenseiten 16 der Zinken 9 zu deren Spitzen 9' hin etwas konvergieren. Unter der Voraussetzung, daß das Material der Arme etwas elastisch ist, kann damit beim Einschieben in Pfeilrichtung 6 über die Achse 1 dies unter Auseinanderdrücken der Zinken 9 mit Schnapp- oder Rastwirkung erfolgen, wobei die dann wieder zurückfedernden Zinken 9 die Arme 4 bzw. deren Enden 4' durch ihre Eigenfederwirkung in der dargestellten Lage an der Achse 1 halten, die sich in einem erweiterten Aufnahmebereich 26 der Schlitzung 13 bfindet. Ferner ist eine Sicherung des Drehteiles an der Achse in deren Längsrichtung, in deren Radialrichtung und insbesondere auch in Umfangsrichtung der Achse zu dieser vorzusehen. Dies kann z.B. an Bunden dieser Achse und bevorzugt durch eine mechanische Verformung gemäß den anderen Ausführungsbeispielen geschehen. Grundsätzlich gilt, daß die Merkmale eines Ausführungsbeispieles bzw. eines Bauteiles eines Ausführungsbeispieles auch bei einem anderen Ausführungsbeispiel, bzw. in Zusammenwirken mit anderen Bauteilen eines weiteren Ausführungsbeispieles vorgesehen sein können.

Die Befestigung der Enden 4' der Arme 4 an der Achse muß nicht durch mechanische Verformung geschehen. Dies kann auch in anderer Weise, z.B. durch Schweißen, Löten oder Verkleben erfolgen.

Das Ausführungsbeispiel der Fig. 4 zeigt zum einen, wie die freien Enden 4' der Arme 4 jeweils zwischen zwei Bunden 17, 18 bzw. 19, 20 wingesteckt und in noch näher zu erläuternder Weise damit verbunden werden. Außerdem zeigt Fig. 4, wie die Arme 4 den Rahmen 25 einer Drehspule halten können.

Die ebenfalls geschlitzten Enden 4' laufen, wie bereits erläutert, in eines der Zinkenpaare 8 bis 12 aus und liegen damit seitlich am Schaft der Achse 1 an. Sie sind in diesem Ausführungsbeispiel ebenfalls durch mechanische Verformung an den jeweils dazugehörigen Bundpaaren 17, 18 bzw. 19, 20 befestigt. Dies kann durch einfaches Zusammenpressen der beiden Bundpaare geschehen oder auch in einer der nachstehend beschriebenen Ausführungsformen der Erfindung. Dabei empfiehlt es sich aber, den Abstand zwischen zwei Bunden eines Paares nur geringfügig größer zu wählen als die Dicke der Zinken.

Gemäß dem Ausführungsbeispiel der Fig. 5a bis 5c hat jeder der Zinken eine äußere Ausnehmung 21, in welche das darüber bzw. darunter befindliche Material eines oder beider dazugehörigen Bunde eingedrückt wird. Auch damit ist die gewünschte Befestigung in allen drei Ebenen, einschließlich der erläuterten einwandfreien Sicherung gegen ein ungewolltes Verdrehen des Drehelementes in Umfangsrichtung zur Achse gegeben. Fig. 5c zeigt in dem Zusammenhang, daß die Innenflächen 22 der Zinken zur Erleichterung des Übersteckens über die Achse nach außen hin divergieren können. Für die mechanische Verformung zwischen den beiden Bundpaaren und den Zinken empfiehlt es sich, je einen Bund eines Paares gegenüber dem anderen Bund dünnwandig zu machen, so daß er mit entsprechend geringerer Kraft in die Ausnehmung 21 eingedrückt werden kann. Hierbei ist das Drehelement außerdem gegen ein Verschieben des allgemein in den Figuren mit 13 bezifferten Schlitzes relativ zur Achse 1 zu sichern. Die Formgebung des Schlitzes 13 ist nicht auf die dargestellten Ausführungsbeispiele beschränkt.

Das Ausführungsbeispiel der Fig. 6, 7 zeigt, daß den Ausnehmungen 21 analoge Ausnehmungen 23 sich auch an den Innenseiten 24 der zugehörigen Zinken 12 befinden können. In sie ist, wie strichpunktiert angedeutet, das Material eines oder beider Bunde (hier mit 17, 18 beziffert) eingedrückt. In Fig. 7 sind diese Bunde nur strichpunktiert dargestellt.

Aus den Ausführungsbeispielen, insbesondere den vorgenannten Fig. 6, 7 ergibt sich, daß man aus Fertigungsgründen die mechanische Verformung, einschließlich Nieten, nur an zwei einander gegenüberliegenden Seiten der Bunde vornehmen wird, aber nicht in der Weise, daß diese Verformung die Achse 1 kreisringförmig umgibt.

**Patentansprüche**

1. Anordnung für oder in Dreheisen bzw. Drehspulinstrumenten mit einer Achse und einem Drehelement, hier eine Drehspule oder ein in Form eines Kreissegmentes ausgebildetes Dreheisen, wobei das Drehelement an der Achse über zwei Arme angebracht ist, dadurch gekennzeichnet, daß die freien Enden (4') der Arme (4) des Drehelementes (5, 25) eine Schlitzung (13) von einer Form und Abmessungen aufweisen, daß die Achse (1) in die Schlitzungen (13) paßt, und daß diese freien Enden (4') von der Seite her, d.h. etwa senkrecht (6) zur Achsenlängsrichtung (7) gabelartig auf die Achse (1) gesteckt sind, wobei die durch die Schlitzung gebildeten Zinken (8 bis 12) dieser freien Enden seitlich neben der Achse liegen und an dieser direkt oder über Zwischenteile gegen Verlagerungen in Achsrichtung, quer zur Achsrichtung und in Umfangsrichtung der Achse unverrückbar befestigt sind.

2. Anordnung nach Anspruch 1, dadurch gekennzeichnet, daß an der Achse ein Bund zur Befestigung des Drehelementes angebracht ist, der bevorzugt mit der Achse einstückig ausgebildet ist, daß ein weiterer Bund an der Achse (1) vorgesehen ist und daß die beiden Arme (4) mit den Zinken (8 bis 12) ihrer freien Enden (4') an diesen beiden Bunden (2, 3; 17, 18, 19, 20) befestigt sind, wobei die Befestigung bevorzugt durch eine mechanische Verformung der Zinken und/oder der Bunde erfolgt.

3. Anordnung nach Anspruch 2, dadurch gekennzeichnet, daß zur Befestigung jedes Endes (4') eines Armes (4) an der Achse (1) zwei Bunde (17, 18, 19, 20) in einem Abstand voneinander angebracht sind, der etwa der Zinkendicke entspricht und das Einschieben der Zinken zwischen diese beiden Bunde bei gleichzeitigem seitlichen Liegen der Zinken neben der Achse, bzw. Absätzen (3) der Achse gestattet und daß durch mechanische Verformung zwischen den jeweiligen Zinken eines freien Endes und einem Bund oder beiden Bunden des dazugehörigen Bundpaares die Befestigung gebildet ist.

4. Anordnung nach Anspruch 3, dadurch gekennzeichnet, daß bei einem Paar zusammengehörender Bunde (17, 18; 19, 20) einer der Bunde dünner ausgebildet ist als der andere Bund.

5. Anordnung nach Anspruch 3 oder 4, dadurch gekennzeichnet, daß eine oder beide Zinken (11, 12) eines oder beider Armenden (4') zumindest eine Ausnehmung (21, 23) aufweisen und daß sich verformtes Material eines oder beider der Bunde (17, 18; 19, 20) in der jeweiligen Ausnehmung bzw. den Ausnehmungen eingedrückt befindet.

6. Anordnung nach einem der Ansprüche 1 bis 5, dadurch gekennzeichnet, daß die Zinken (10) eines oder beider der freien Armenden (4') einen gegenüber der Schlitzung (13) erweiterten Aufnahmebereich (26) für die Achse (1) bilden.

7. Anordnung nach einem der Ansprüche 1 bis 6, dadurch gekennzeichnet, daß die Zinken eines oder beider der freien Armenden federnd ausgebildet und mit Schnapp- bzw. Rastwirkung über die Achse gesteckt sind.

8. Anordnung nach einem der Ansprüche 2 bis 7, dadurch gekennzeichnet, daß sich die Materialverformungen der Zinken und/oder Bunde nur an zwei einander gegenüberliegenden Seiten der Achse befinden.

9. Anordnung nach einem der Ansprüche 1 bis 8, dadurch gekennzeichnet, daß die Arme (4) aus Metall bestehen, bevorzugt gestanzt sind.

10. Anordnung nach einem der Ansprüche 1 bis 9, dadurch gekennzeichnet, daß die Achse, einschließlich der Bunde, aus Buntmetall, insbesondere Aluminium besteht.

**Claims**

1. Arrangement for or in moving-iron or moving-coil instruments with an axle and a rotary element, here a moving coil or a moving iron constructed in the form of a circular segment, wherein the rotary element is mounted at the axle by way of two arms, characterised thereby, that the free ends (4') of the arms (4) of the rotary element (5, 25) have a slotting (13) of such a shape and dimensions that the axle (1) fits into the slottings (13) and that these free ends (4') are pushed in the manner of a fork over the axle (1) from the side, i.e. about perpendicularly (6) to the longitudinal direction (7) of the axle, wherein the tines (8 to 12) formed by the slotting of these free ends lie laterally beside the axle and are fastened to this directly or by way of intermediate parts to be immovable against redispositions in axial direction, transversely to the axial direction and in circumferential direction of the axle.

2. Arrangement according to claim 1, characterised thereby, that a collar for the fastening of the rotary element is mounted at the axle and preferably constructed to be integral with the axle, that a further collar is provided at the axle (1) and that both the arms (4) are fastened by the tines (8 to 12) of their free ends (4') to both these collars (2, 3; 17, 18, 19, 20), wherein the fastening preferably takes place by a mechanical deformation of the tines and/or the collars.

3. Arrangement according to claim 2, characterised thereby, that for the fastening of each end (4') of an arm (4) at the axle (1), two collars (17, 18, 19, 20) are mounted at a spacing each from the other, which corresponds to about the tine thickness and permits the pushing of the tines between these two collars with simultaneous lateral lying of the tines beside the axle or stepped portions (3) of the axle and that the fastening is formed through mechanical deformation between the respective tines of a free end and a collar or both collars of the associated pair of collars.

4. Arrangement according to claim 3, characterised thereby, that in the case of a pair of collars (17, 18, 19, 20) belonging together, one of the collars is constructed to be thinner than the other collar.

5. Arrangement according to claim 3 or 4, characterised thereby, that one or both tines (11, 12) of one or both arm ends (4') have at least one recess (21, 23) and that deformed material of one of both of the collars (17, 18, 19, 20) is disposed impressed into the respective recess or the recesses.

6. Arrangement according to one of the claims 1 to 5, characterised thereby, that the tines (10) of one or both free arm ends (4') form a reception region (26), which is widened by comparison with the slotting (13), for the axle (1).

7. Arrangement according to one of the claims 1 to 6, characterised thereby, that the tines of one or both free arm ends are constructed to be resilient and plugged with snap or detent action over the axle.

8. Arrangement according to one of the claims 2 to 7, characterised thereby, that the material deformations of the tines and/or the collars are situated only at two mutually opposite sides of the axle.

9. Arrangement according to one of the claims 1 to 8, characterised thereby, that the arms (4) consist of metal and are preferably punched.

10. Arrangement according to one of the claims 1 to 9, characterised thereby, that the axle inclusive of the collars consists of non-ferrous metal, preferably aluminium.

**Revendications**

1. Dispositif pour ou dans des instruments à fer ou à cadre mobile, présentant un axe et un élément rotatif matèrialisé dans le présent cas, par une bobine à cadre mobile ou par un fer mobile réalisé sous la forme d'un secteur circulaire, l'élément rotatif étant implanté sur l'axe par l'intermédiaire de deux bras, caractérisé par le fait que les extrémités libres (4') des bras (4) de l'élément rotatif (5, 25) comportent une entaille (13) d'une forme et de dimensions telles que l'axe (1) s'adapte dans les entailles (13) ; et par le fait que ces extrémités libres (4') sont emboîtées sur l'axe (1) à la manière d'une fourche, par le côté, c'est-à-dire à peu près perpendiculairement (6) à la direction longitudinale axiale (7), les fourchons (8 à 12) de ces extrémités libres, formés par l'entaille, jouxtant latéralement l'axe et étant verrouillés à demeure sur ce dernier, directement ou par l'intermédiaire de pièces intercalaires, en étant empêchés d'effectuer des déports dans le sens axial, transversalement par rapport au sens axial et dans le sens périphérique de l'axe.

2. Dispositif selon la revendication 1, caractérisé par le fait qu'une collerette, réalisée de préférence d'une seule pièce avec l'axe, est ménagée sur cet axe en vue de la fixation de l'élément rotatif ; par le fait qu'une autre collerette est prévue sur l'axe (1) ; et par le fait que les deux bras (4) sont fixés à ces deux collerettes (2, 3 ; 17, 18, 19, 20) par les fourchons (8 à 12) de leurs extrémités libres (4'), la fixation étant de préférence assurée par une déformation mécanique des fourchons et/ou des collerettes.

3. Dispositif selon la revendication 2, caractérisé par le fait que, en vue de la fixation de chaque extrémité (4') d'un bras (4) à l'axe (1), deux collerettes (17, 18, 19, 20) sont ménagées à une distance mutuelle qui correspond sensiblement à l'épaisseur des fourchons, et autorise l'insertion des fourchons entre ces deux collerettes lorsque, simultanément, lesdits fourchons sont latéralement appliqués contre l'axe, ou contre des décrochements (3) de l'axe ; et par le fait que la fixation est établie par déformation mécanique intervenant entre les fourchons considérés d'une extrémité libre, et une collerette ou les deux collerettes de la paire de collerettes correspondante.

4. Dispositif selon la revendication 3, caractérisé par le fait que, dans une paire de collerettes associées (17, 18 ; 19, 20), l'une des collerettes est réalisée plus mince que l'autre collerette.

5. Dispositif selon la revendication 3 ou 4, caractérisé par le fait qu'un ou les deux fourchons (11, 12) de l'une ou des deux extrémités (4') d'un bras comporte(nt) au moins un évidement (21, 23) ; et par le fait que du matériau déformé de l'une ou des deux collerettes (17, 18 ; 19, 20) est repoussé dans l'évidement considéré, respectivement dans les évidements.

6. Dispositif selon l'une des revendications 1 à 5, caractérisé par le fait que les fourchons (10) de l'une ou des deux extrémités libres (4') d'un bras forment, pour l'axe (1), une zone réceptrice (26) élargie par rapport à l'entaille (13).

7. Dispositif selon l'une des revendications 1 à 6, caractérisé par le fait que les fourchons de l'une ou des deux extrémités libres d'un bras sont réalisés doués d'élasticité, et sont respectivement emboîtés sur l'axe par un effet de déclic ou d'encrantage.

8. Dispositif selon l'une des revendications 2 à 7, caractérisé par le fait que les déformations de matière des fourchons et/ou collerettes se trouvent uniquement sur deux côtés de l'axe qui sont mutuellement opposés.

9. Dispositif selon l'une des revendications 1 à 8, caractérisé par le fait que les bras (4) consistent en un métal et sont, de préférence, venus d'estampage.

10. Dispositif selon l'une des revendications 1 à 9, caractérisé par le fait que l'axe, y compris les collerettes, consiste en un métal lourd non ferreux, notamment en de l'aluminium.

_Fig . 1_

_Fig . 2 a_

_Fig . 2 b_

_Fig . 3_

9

Fig. 5a

Fig. 5b

Fig. 4

Fig. 5c

Fig. 6

Fig. 7